# EUROPÄISCHE PATENTSCHRIFT

(11) **EP 3 170 374 B1**
(45) Veröffentlichungstag und Bekanntmachung des Hinweises auf die Patenterteilung: **30.12.2020**
(21) Anmeldenummer: 15735890.4
(22) Anmeldetag: 30.06.2015
(51) Int. Cl.: H05K 1/02, H05K 1/14, H05K 3/30, F25D 29/00, F24C 7/08, A47L 15/42, G02F 1/1333, D06F 39/00, H05K 7/14

(54) **ELEKTRONISCHE BENUTZERSCHNITTSTELLE MIT EINER SEPARATEN STEUERPLATINE UND HAUSHALTSGERÄT MIT EINER SOLCHEN BENUTZERSCHNITTSTELLE**
ELECTRONIC USER INTERFACE HAVING A SEPARATE CONTROL CIRCUIT BOARD AND DOMESTIC APPLIANCE HAVING SUCH A USER INTERFACE
INTERFACE UTILISATEUR ÉLECTRONIQUE ÉQUIPÉE D'UNE CARTE DE COMMANDE SÉPARÉE ET APPAREIL MÉNAGER ÉQUIPÉ D'UNE TELLE INTERFACE UTILISATEUR

(30) Priorität: 16.07.2014 DE 102014213792
(43) Veröffentlichungstag der Anmeldung: 24.05.2017
(73) Patentinhaber: BSH Hausgeräte GmbH, 81739 München (DE)
(72) Erfinder: ADAM, Paul, 93161 Sinzing / Viehhausen (DE); MAKHTYUK, Roman, 93087 Alteglofsheim (DE); REINDL, Karl, 93059 Regensburg (DE); ZETTEL, Martin, 97440 Werneck (DE)
(86) Internationale Anmeldenummer: PCT/EP2015/064835
(87) Internationale Veröffentlichungsnummer: WO 2016/008718

(56) Entgegenhaltungen:
- WO-A1-2013/161142
- DE-A1-102011 077 896
- DE-C1- 19 639 954

## Beschreibung

Die Erfindung betrifft eine elektronische Benutzerschnittstelle, aufweisend eine Leiterplatte, wenigstens ein Ein- und/oder Ausgabemittel, welches mit der Leiterplatte elektrisch verbunden ist, sowie wenigstens einen Halter, durch den das wenigstens eine Ein- und/oder Ausgabemittel mechanisch an der Leiterplatte befestigt ist. Die Erfindung betrifft außerdem ein Haushaltsgerät, aufweisend eine solche elektronische Benutzerschnittstelle.

Die DE 34 08 176 A1 beschreibt einen Montagerahmen zur Befestigung einer LCD-Anzeige auf einer Leiterplatte, wobei der Kontakt zwischen der LCD-Anzeige und den Leiterbahnen der Leiterplatte über einen zwischen einer Kontaktreihe der LCD-Anzeige und einer entsprechenden Kontaktreihe der Leiterplatte eingepressten Leitgummi hergestellt wird. Die LCD-Anzeige wird in Längsrichtung der Kontaktreihe an eine Anschlagkante des Montagerahmens angedrückt, wobei der Montagerahmen einen in eine Bohrung der Leiterplatte eingreifenden Justierbolzen aufweist, dessen Lage bezüglich der Anschlagkante genau definiert ist und der Justierbolzen in der Nähe der Anschlagkante angeordnet ist. An gegenüberliegenden Längsseiten des Montagerahmens sind zwei Ansätze mit Löchern zur Verschraubung des Montagerahmens mit der Leiterplatte vorgesehen.

Die DE 196 39 954 C1 beschreibt eine Anzeigeeinheit für eine elektronische Waage mit einem LC-Display, einem Seriell/Parallel-Wandler zur Ansteuerung der einzelnen LCD-Segmente und mit einer Platine als Träger, wobei die Trägerplatine nur einseitig kaschiert ist und einen Schlitz aufweist, auf der Vorderseite der Trägerplatine das LC-Display angeordnet ist, und auf der Rückseite der Trägerplatine eine zweite, kleinere Platine mit dem Seriell/Parallel-Wandler angeordnet ist, wobei die elektrische Verbindung zwischen dem LC-Display und der zweiten Platine mittels abgewinkelter Kontakte des LC-Displays durch den Schlitz in der Trägerplatine hindurch erfolgt.

Die DE 10 2011 077 896 A1 beschreibt eine Bedien- und Anzeigeeinrichtung für ein Haushaltsgerät, mit Bedienmitteln zum Einstellen zumindest eines Parameters eines Betriebsprozesses des Haushaltsgeräts.

Die WO 2013/161142 A1 beschreibt eine Struktur zum Befestigen eines ersten Substrats und eines zweiten Substrats, welche durch einen Zwischensubstratverbinder verbunden sind, und welche befestigt sind und welche einander mit einem Raum überlappen, beinhaltet ein Abstandshalterteil, welches zwischen dem ersten Substrat und dem zweiten Substrat angeordnet ist, und welches einen Raum zwischen dem ersten Substrat und dem zweiten Substrat bei einem vorab festgelegten Abstand beibehält, einen Druckabschnitt, welcher das zweite Substrat zu dem ersten Substrat hindrückt, und ein Sperrteil, welches in dem ersten Substrat befestigt ist.

Die Aufgabe der Erfindung ist es, eine elektronische Benutzerschnittstelle, insbesondere eine elektronische Benutzerschnittstelle eines Haushaltsgeräts zu schaffen, die universell auf einfache, insbesondere kostengünstige Weise hergestellt, insbesondere in unterschiedlichen Ausführungen einfach konfiguriert werden kann.

Die Aufgabe der Erfindung wird gelöst durch eine elektronische Benutzerschnittstelle, aufweisend eine Leiterplatte, wenigstens ein Ein- und/oder Ausgabemittel, welches mit der Leiterplatte elektrisch verbunden ist, sowie wenigstens einen Halter, durch den das wenigstens eine Ein- und/oder Ausgabemittel mechanisch an der Leiterplatte befestigt ist, des Weiteren aufweisend eine von der Leiterplatte separate Steuerplatine, die wenigstens ein zum Ansteuern des wenigstens einen Ein- und/oder Ausgabemittels ausgebildetes Steuerbauelement aufweist, und die mittels eines Platinenhalters mechanisch an der Leiterplatte befestigt ist, wobei die von der Leiterplatte separate Steuerplatine mittels des Platinenhalters lediglich mechanisch an der Leiterplatte befestigt ist, ohne dass eine elektrische Kontaktierung der Steuerplatine an die Leiterplatte über den Platinenhalter erfolgt und die Steuerplatine mittels wenigstens einer vom Platinenhalter separaten Steuerleitung elektrisch mit der Leiterplatte verbunden ist, über welche Steuerleitung das wenigstens eine Ein- und/oder Ausgabemittel durch die Steuerplatine angesteuert ist. Die von der Leiterplatte separate Steuerplatine, die wenigstens ein zum Ansteuern des wenigstens einen Ein- und/oder Ausgabemittels ausgebildetes Steuerbauelement aufweist, ist somit mittels des Platinenhalters ausschließlich mechanisch an der Leiterplatte befestigt.

Die Leiterplatte kann dabei zumindest weitegehend oder sogar ausschließlich nur Leiterbahnen aufweisen, die zur Verdrahtung des wenigstens einen Ein- und/oder Ausgabemittels oder der mehreren Ein- und/oder Ausgabemittel vorgesehen sind, wobei zumindest die wesentlichen oder sogar alle Steuerbauelemente von der Leiterplatte getrennt auf einer separaten Steuerplatine untergebracht sind. Die von der Leiterplatte separate Steuerplatine ist dabei außerdem mittels des erfindungsgemäßen Platinenhalters lediglich mechanisch an der Leiterplatte befestigt, ohne dass eine elektrische Kontaktierung der Steuerplatine an die Leiterplatte über den Platinenhalter erfolgt. Eine elektrische Kontaktierung der Steuerplatine an die Leiterplatte erfolgt vielmehr ausschließlich über eine vom Platinenhalter separate Steuerleitung.

Die Steuerplatine ist somit allein mittels wenigstens einer vom Platinenhalter separaten Steuerleitung elektrisch mit der Leiterplatte verbunden, über welche Steuerleitung das wenigstens eine Ein- und/oder Ausgabemittel durch die Steuerplatine angesteuert ist. Das wenigstens eine Ein- und/oder Ausgabemittel kann insbesondere ein elektronisches Display, ein elektrisches Leuchtmittel und/oder eine Touch-Folie sein. Die separate Steuerleitung kann insbesondere eine als Flachbandkabel und/oder als ein FPC-Kabel ausgebildete Steuerleitung sein.

Die Steuerplatine ist also mittels wenigstens einer vom Platinenhalter separaten Steuerleitung elektrisch mit der Leiterplatte verbunden, über welche Steuerleitung das wenigstens eine Ein- und/oder Ausgabemittel durch die Steuerplatine angesteuert ist. Die Steuerplatine ist demgemäß mittels wenigstens einer vom Platinenhalter separaten Steuerleitung elektrisch mit der Leiterplatte verbunden, über welche Steuerleitung das wenigstens eine Ein- und/oder Ausgabemittel durch die Steuerplatine angesteuert ist.

Die Steuerplatine kann in einer speziellen Ausführungsform ausschließlich über die wenigstens eine vom Platinenhalter separate Steuerleitung, insbesondere eine als Flachbandkabel und/oder als ein FPC-Kabel ausgebildete Steuerleitung, elektrisch mit der Leiterplatte verbunden sein.

Mittels der erfindungsgemäßen Leiterplatte und der durch den Platinenhalter mechanisch und durch die vom Platinenhalter separate Steuerleitung elektrisch verbundene, separate Steuerplatine kann eine autarke Elektronikplattform geschaffen werden, durch welche mit einer möglichst geringen Anzahl an Varianten von Bauteilen eine möglichst große Vielfalt an unterschiedlichen Benutzerschnittstellen geschaffen werden kann. So können in Abhängigkeit des jeweiligen Haushaltsgerätetyps, der jeweiligen Gerätemarke und/oder einer jeweiligen Wertigkeitsklasse innerhalb eines Haushaltsgerätetyps, mit einer möglichst geringen Anzahl von Leiterplatten und/oder Steuerplatinen, insbesondere im Speziellen auch mit einer einzigen Leiterplatte und/oder einzigen Steuerplatine eine hohe Anzahl von Varianten an elektronischen Benutzerschnittstellen geschaffen werden.

So kann eine erfindungsgemäße elektronische Benutzerschnittstelle beispielsweise wahlweise ein, zwei oder drei elektronische Displays aufweisen, und/oder ein oder mehrere Schalter, Tasten, insbesondere Touch-Eingabemittel, wie Touchfolien aufweisen. Diese Ein- und/oder Ausgabemittel können in unterschiedlichen Anzahlen und/oder Anordnungen an der elektronischen Benutzerschnittstelle ausgebildet sein.

Die erfindungsgemäße Steuerplatine kann ein sogenanntes Multimedia-Board bilden, welches wenigstens ein programmierbaren Steuerbauelement aufweisen kann, das je nach Bestückung der Leiterplatte mit ein oder mehreren, insbesondere unterschiedlichsten Ein- und/oder Ausgabemitteln, unterschiedlich programmiert sein kann.

Die Leiterplatte dient neben der elektrischen Kontaktierung auch zur mechanischen Befestigung der unterschiedlichen Ein- und/oder Ausgabemittel an der Leiterplatte. Der erfindungsgemäße Platinenhalter dient dabei der mechanischen Befestigung der Steuerplatine an der Leiterplatte. So bildet die elektronische Benutzerschnittstelle eine variable, aber kompakte Baueinheit.

Die Leiterplatte kann mit den unterschiedlichen Ein- und/oder Ausgabemitteln vorbestückt werden. Auch die separate Steuerplatine kann vorbestückt und parallel zur Herstellung der Leiterplatte programmiert werden. Die Leiterplatte und die Steuerplatine können anschließend endmontiert werden.

Der Platinenhalter kann einen Halterahmen aufweisen, in den die Steuerplatine eingesetzt ist. Der Platinenhalter kann insbesondere einen Halterahmen aufweisen, in den die Steuerplatine eingesetzt ist, wobei der Halterahmen wenigstens eine Rastvorrichtung aufweist, durch welche der Halterahmen auf der Leiterplatte befestigt ist.

Der Halterahmen kann dabei ausgebildet sein, die Steuerplatine an ihren Rändern zu umfassen. Alternativ oder ergänzend kann der Halterahmen ausgebildet sein, die Steuerplatine in einer zur Leiterplatte parallelen Ebene in einem Abstand, insbesondere in einem geringen Abstand von der Leiterplatte mechanisch zu halten.

Der Platinenhalter kann einen, die in den Platinenhalter eingesetzte Steuerplatine abdeckenden Deckel aufweisen.

Der Deckel kann ausgebildet sein, die mit Bauelementen bestückte Oberseite der Steuerplatine vor mechanischen Schäden und/oder Spritzwasser zu schützen. Alternativ kann der der Deckel ausgebildet sein, die von den Bauelementen abgewandte Unterseite der Steuerplatine, welche Leiterbahnen und Lötpunkte aufweist, vor elektrischen Kurzschlüssen, mechanischen Schäden und/oder Spritzwasser zu schützen.

Das wenigstens eine Ein- und/oder Ausgabemittel kann ein elektronisches Display sein, das an die Leiterplatte elektrisch kontaktiert ist, und die elektronische Benutzerschnittstelle kann dabei einen Display-Halterahmen aufweisen, der an der Leiterplatte mechanisch befestigt ist und in den das wenigstens eine elektronische Display eingesetzt ist.

Mittels des Display-Halterahmens ist eine Vormontage des wenigstens einen elektronischen Displays an dem Display-Halterahmen möglich. Eine solche Vormontage des elektronischen Displays an dem Display-Halterahmen kann fern ab der eigentlichen Fertigungslinie des Haushaltsgeräts erfolgen. Außerdem kann die so erhaltene Baugruppe von wenigstens einem elektronischen Display und dem Display-Halterahmen in einem ergänzenden oder separaten Montageschritt auf einfache Weise auf der Leiterplatte vormontiert werden. Eine Endmontage der kompletten Benutzerschnittstelle kann dann in einer eigentlichen Fertigungslinie, insbesondere der Fertigungslinie eines Haushaltsgeräts erfolgen. Die Montage kann dabei wahlweise manuell oder automatisiert, insbesondere für eine Großserienfertigung, in gleicher montagefreundlicher und kostengünstiger Weise erfolgen.

Insbesondere Haushaltsgeräte wie Kältegerät, Geschirrspüler, Waschmaschinen, Backherde oder dgl. weisen im Allgemeinen mehrere Bedientasten, Anzeigemittel bzw. wenigstens ein Ein- und/oder Ausgabemittel auf. Die Bedientasten, die Anzeigemittel bzw. das wenigstens eine Ein- und/oder Ausgabemittel können in einer Frontblende des Haushaltsgeräts untergebracht sein. Im Inneren des Haushaltsgeräts sind dann, mit Ausnahme der sichtbaren Teile der Bedientasten, der Anzeigemittel bzw. der Ein- und/oder Ausgabemittel selbst, optisch hinter der Frontblende verborgen, die übrigen Komponenten einer die Ein- und/oder Ausgabemittel umfassenden Benutzerschnittstelle angeordnet.

Die Benutzerschnittstelle umfasst demgemäß eine Leiterplatte, welche in einem beispielsweise in das Haushaltsgerät eingebautem Zustand mit einer nicht näher dargestellten Steuervorrichtung des Haushaltsgeräts elektrisch verbunden ist. Auf der Leiterplatte können ein oder mehrere Ein- und/oder Ausgabemittel elektrisch kontaktiert angeordnet sein. Das wenigstens eine Ein- und/oder Ausgabemittel kann wenigstens ein elektronisches Display umfassen. Das wenigstens eine elektronische Display kann auch als ein Touch-Display ausgebildet sein, welches insoweit dann die Bedientasten mit aufweist. Das wenigstens eine elektronische Display kann insbesondere ein TFT-Display, oder ganz allgemein beispielsweise ein LCD-Bildschirm oder ein LED-Display sein. Generell kann es sich auch um ein Touchscreen handeln.

Indem ein Display-Halterahmen vorgesehen ist, in den das wenigstens eine elektronische Display eingesetzt ist, und der Display-Halterahmen eine Rastvorrichtung aufweist, die ausgebildet ist, den Display-Halterahmen auf der Leiterplatte zu befestigen, können ein oder mehrere elektronische Displays in unterschiedlicher Anzahl und/oder verschiedenen Anordnungen auf einer Leiterplatte befestigt werden, ohne dass für jede Bauform eine individuelle Leiterplatte gefestigt werden müsste. Es kann insbesondere eine einheitliche Leiterplatte für unterschiedliche Geräte, insbesondere unterschiedliche Haushaltsgeräte verwendet werden, die jedoch in ihrem Erscheinungsbild aufgrund der unterschiedlichen Anzahl und/oder verschiedenen Anordnungen von elektronischen Displays sich anders darstellen. Auch die elektronischen Displays können in identischer Bauart und/oder Baugröße für verschiedene Gerätearten verwendet werden. Die Befestigung des wenigstens einen elektronischen Displays auf der Leiterplatte erfolgt durch einen erfindungsgemäßen Display-Halterahmen, der insoweit an die Geräteart angepasst ist. Die Befestigung und Positionierung des wenigstens einen elektronischen Displays erfolgt mittels der wenigstens einen Rastvorrichtung. Durch den erfindungsgemäßen Display-Halterahmen können insbesondere zwei oder mehrere elektronische Displays gemeinsam an der Leiterplatte mechanisch befestigt werden.

Die Leiterplatte kann dazu wenigstens eine Öffnung und/oder wenigstens eine Aussparung aufweisen und die Rastvorrichtung des Display-Halterahmens kann wenigstens einen Rastzapfen umfassen, der in seinem eingerasteten Zustand in die wenigstens eine Öffnung der Leiterplatte eingreift und/oder die wenigstens eine Aussparung der Leiterplatte umgreift.

Der wenigstens eine Rastzapfen kann in einer speziellen Ausführungsform der Erfindung einen federelastischen Schaft und einen an einem freien Ende des federelastischen Schafts angeordneten Rasthaken aufweisen. Der Schaft des Rastzapfens durchdringt dann die zugeordnete Öffnung in der Leiterplatte und der Rasthaken hintergreift einen Randabschnitt der Öffnung der Leiterplatte formschlüssig. Jeder Rastzapfen und damit jeder federelastische Schaft und Rasthaken kann einstückig mit dem Display-Halterahmen als ein Kunststoffspritzgussteil hergestellt sein.

Für verschiedene Benutzerschnittstellen unterschiedlicher Geräte, insbesondere Haushaltsgeräte, kann in einer Ausführungsvariante der Erfindung dieselbe Baurat einer Leiterplatte mit den gleichen Öffnungen und/oder Aussparungen für verschiedene Geräte, insbesondere Haushaltsgeräte verwendet werden, wobei auch die wenigstens eine Rastvorrichtung, insbesondere der wenigstens eine Rastzapfen für alle verschiedene Geräte, insbesondere Haushaltsgeräte dieselbe, zu den Öffnungen und/oder Aussparungen der Leiterplatte passende Position am Display-Halterahmen einnimmt, aber der Display-Halterahmen selbst mit verschiedenen, insbesondere verschieden in Anzahl und/oder Anordnung ausgeführten Rahmenabteilen ausgeführt sein kann. Es kann auch derselbe Display-Halterahmen, der mehrere, beispielsweise drei Rahmenabteile aufweist, mit einer geringeren Anzahl von elektronischen Display ausgestattet sein, beispielsweise bei drei Rahmenabteilen nur mit zwei oder sogar nur einem einzigen elektronischen Display ausgestattet sein, um verschieden erscheinende Benutzerschnittstellen mit derselben Leiterplatte und/oder demselben Display-Halterahmen realisieren zu können. Anders ausgedrückt kann die erfindungsgemäße Benutzerschnittstelle einen Display-Halterahmen aufweisen, der wenigstens zwei Rahmenabteile aufweist, wobei wenigstens ein Rahmenabteil von einem elektronischen Display auch unbestückt bleiben kann.

Der Display-Halterahmen kann eine der Leiterplatte zugewandte Bodenseite aufweisen, von der sich wenigstens ein Zentrierzapfen wegerstreckt, insbesondere mindestens zwei Zentrierzapfen wegerstrecken, welche in einer an der Leiterplatte befestigten Montageposition des Display-Halterahmens in korrespondierende Löcher in der Leiterplatte eingreifen.

Die Zentrierzapfen greifen in einer an der Leiterplatte befestigten Montageposition des Display-Halterahmens in korrespondierende Löcher in der Leiterplatte ein. Indem die Zentrierzapfen während des Montagevorgangs in die Löcher der Leiterplatte eindringen, kann der gesamte Display-Halterahmen in seiner relativen Orientierung bezüglich der Leiterplatte ausgerichtet werden. Durch eine genaue Ausrichtung des Display-Halterahmens bezüglich der Leiterplatte können die Rastzapfen besonders genau und treffsicher in die Öffnungen der Leiterplatte eindringen, so dass der Montagevorgang des Display-Halterahmens auf der Leiterplatte verbessert ist.

Generell kann die Rastvorrichtung, insbesondere der wenigstens eine Rastzapfen und/oder der wenigstens eine Zentrierzapfen einstückig mit dem Display-Halterahmen ausgebildet sein. Die Rastvorrichtung, insbesondere der wenigstens eine Rastzapfen und/oder der wenigstens eine Zentrierzapfen können also an dem Kunststoffspritzgussteil des Display-Halterahmens mit angeformt sein.

Der Display-Halterahmen kann also wenigstens zwei Rahmenabteile aufweisen, von denen jedes Rahmenabteil ausgebildet ist, ein elektronisches Display aufzunehmen.

Der Display-Halterahmen, der Lichtleiter-Halter und/oder der Platinenhalter, insbesondere der Halterahmen, in den die Steuerplatine eingesetzt ist, können als ein einteiliger gemeinsamer Halter ausgebildet sein.

Das wenigstens eine Ein- und/oder Ausgabemittel kann ein elektrisches Leuchtmittel aufweisen, das zur Erzeugung von Licht aus elektrischer Energie auf der Leiterplatte kontaktiert ist, und das wenigstens einen Lichtleiter, der eine Einkopplungsfläche, eine Auskopplungsfläche und einen Lichtleitabschnitt aufweist, der ausgebildet ist, über die Einkopplungsfläche eintretendes Licht des Leuchtmittels an die Auskopplungsfläche zu leiten, welche an ein Anzeigemittel der elektronischen Benutzerschnittstelle optisch angekoppelt ist, und an der Leiterplatte ein Lichtleiter-Halter befestigt ist, der den wenigstens einen Lichtleiter trägt.

Der Lichtleiter-Halter kann wenigstens eine Aufnahmetasche aufweisen, in die der wenigstens eine Lichtleiter eingesetzt ist.

Die Benutzerschnittstelle kann demgemäß eine Leiterplatte umfassen, welche in einem beispielsweise in das Haushaltsgerät eingebautem Zustand mit einer nicht näher dargestellten Steuervorrichtung des Haushaltsgeräts elektrisch verbunden ist. Auf der Leiterplatte können mehrere elektrische Leuchtmittel elektrisch kontaktiert angeordnet sein. Die Leuchtmittel sind zur Erzeugung von Licht aus elektrischer Energie auf der Leiterplatte kontaktiert. Die Leuchtmittel können in gleichmäßigen Abständen voneinander entfernt, entlang einer geraden Linie aufgereiht auf der Leiterplatte angeordnet sein. Die Leuchtmittel können durch LEDs gebildet werden, insbesondere von LEDs in SMD-Bauweise, d.h. als oberflächenmontierte Bauelemente gebildet. Statt solcher lichtemittierender Halbleiter-Bauelemente, können in variierten Ausführungsformen die Leuchtmittel jedoch beispielsweise auch von Glühlampen gebildet werden. Es können mehrere geometrisch gleiche Lichtleiter vorgesehen sein, die in dem Lichtleiter-Halter befestigt sind. Um ein Lichtübersprechen zwischen einzelnen Lichtleitern zu verhindern, kann wie weiter unten näher erläutert, der Lichtleiter-Halter eine das Lichtübersprechen verhindernde Einrichtung aufweisen. Durch die im Folgenden beschriebene Ausgestaltung der Lichtleiter kann auch eine möglichst gleichmäßige und helle Ausleuchtung von Symbolen, Zahlen und/oder Buchstaben oder sonstigen Zeichen der Anzeige erreicht werden.

Um das von dem jeweiligen Leuchtmittel ausgestrahlte Licht an das dazugehörige Anzeigemittel zu leiten, ist jedem Leuchtmittel ein separater Lichtleiter zugeordnet. Die Lichtleiter können alle dieselbe Gestalt aufweisen. Jeder Lichtleiter ist als ein separates Bauteil ausgeführt. Jeder Lichtleiter kann eine grob annähernd würfelförmige Gestalt aufweisen. Jeder Lichtleiter kann insoweit eine rechteckige, insbesondere quadratische Oberseite und eine rechteckige, insbesondere quadratische Unterseite, sowie wenigstens vier Seitenwände aufweisen.

Jeder Lichtleiter weist eine Einkopplungsfläche, eine Auskopplungsfläche und einen Lichtleitabschnitt auf, der ausgebildet ist, über die Einkopplungsfläche eintretendes Licht des Leuchtmittels an die Auskopplungsfläche zu leiten. Ein insbesondere aus transparentem Kunststoff gefertigte, oberseitig von der Auskopplungsfläche und unterseitig von der Einkopplungsfläche begrenzte Grundkörper des Lichtleiters bildet den Lichtleitabschnitt.

Die Anzeigemittel können unmittelbar von den Oberseiten der Lichtleiter, d.h. von den Auskopplungsflächen gebildet werden. Anders ausgedrückt kann das Anzeigemittel durch ein Aufleuchten der Auskopplungsfläche des Lichtleiters aktiviert werden. Alternativ kann das Anzeigemittel aber auch von einem auf dem Lichtleiter, d.h. der Auskopplungsfläche angebrachten, insbesondere aufgeklebten oder aufgedruckten Symbol, einer Zahl oder Buchstaben gebildet werden, welche über die Auskopplungsfläche des Lichtleiter von dem Leuchtmittel angeleuchtet, hinterleuchtet bzw. umleuchtet wird. Alle diese und analogen Ausgestaltungen haben insoweit aber gemeinsam, dass die Auskopplungsfläche optisch an das Anzeigemittel angekoppelt ist. Das Anzeigemittel ist dann insoweit aktiviert, wenn das Leuchtmittel leuchtet und das ausgesendete Licht über den Lichtleiter das Anzeigemittel beleuchtet, hinterleuchtet bzw. umleuchtet. Das Anzeigemittel ist demgemäß dann nicht aktiviert, wenn das Leuchtmittel nicht leuchtet, also ausgeschalten ist und kein Licht über den Lichtleiter das Anzeigemittel beleuchtet, hinterleuchtet bzw. umleuchtet, d.h. das Anzeigemittel dunkel bleibt.

Der Lichtleiter-Halter weist vorzugsweise wenigstens eine Aufnahmetasche auf, in die der wenigstens eine Lichtleiter eingesetzt ist. Die erfindungsgemäße Benutzerschnittstelle kann also einen Lichtleiter-Halter aufweisen, der an der Leiterplatte befestigt ist und der wenigstens eine Aufnahmetasche aufweist, in die der wenigstens eine Lichtleiter eingesetzt ist. Bei mehreren Anzeigemitteln sind eine entsprechende Anzahl von Lichtleitern und eine entsprechende gleiche Anzahl von Aufnahmetaschen vorgesehen. Ein einstückiger Lichtleiter-Halter kann also beispielsweise drei, fünf oder sieben Aufnahmetaschen aufweisen. In äquivalenten Ausführungsvarianten kann der Lichtleiter-Halter eine beliebige andere Anzahl von Lichtleitern und eine entsprechende gleiche Anzahl von Aufnahmetaschen aufweisen. Entsprechend der Anordnung der Leuchtmittel können die Aufnahmetaschen und die Lichtleiter in dem Lichtleiter-Halter auch in gleichmäßigen Abständen voneinander entfernt, entlang einer geraden Linie aufgereiht angeordnet sein.

Die Erfindung betrifft demgemäß auch ein Haushaltsgerät, insbesondere ein Kältegerät, einen Herd, ein Kochfeld, eine Dunstabzugshaube, eine Geschirrspülmaschine, eine Waschmaschine, ein Wäschetrockner oder ein Kaffeevollautomat, das eine erfindungsgemäße elektronische Benutzerschnittstelle, wie beschrieben, aufweist.

Zwei konkrete Ausführungsbeispiele einer erfindungsgemäßen elektronischen Benutzerschnittstelle sind in der nachfolgenden Beschreibung unter Bezugnahme auf die beigefügten Figuren näher erläutert. Konkrete Merkmale dieser Ausführungsbeispiele können unabhängig davon, in welchem konkreten Zusammenhang sie erwähnt sind, gegebenenfalls auch einzeln oder in Kombination betrachtet, allgemeine Merkmale der Erfindung darstellen.

Es zeigen:
- Fig. 1: eine perspektivische schematische Darstellung eines beispielhaften Haushaltsgeräts in Art einer Waschmaschine mit einer erfindungsgemäßen elektronischen Benutzerschnittstelle,
- Fig. 2: eine Explosionsdarstellung eines ersten Ausführungsbeispiels einer erfindungsgemäßen elektronischen Benutzerschnittstelle,
- Fig. 3: perspektivische Darstellungen der elektronischen Benutzerschnittstelle gemäß Fig. 2 im Zusammenbau in einer Draufsicht und in einer Ansicht von unten,
- Fig. 4: eine Explosionsdarstellung eines zweiten Ausführungsbeispiels einer erfindungsgemäßen elektronischen Benutzerschnittstelle, und
- Fig. 5: eine perspektivische Darstellung der elektronischen Benutzerschnittstelle gemäß Fig. 4 im Zusammenbau in einer Draufsicht.

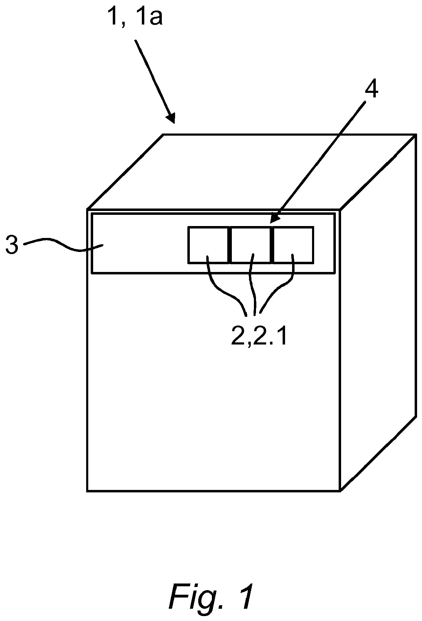

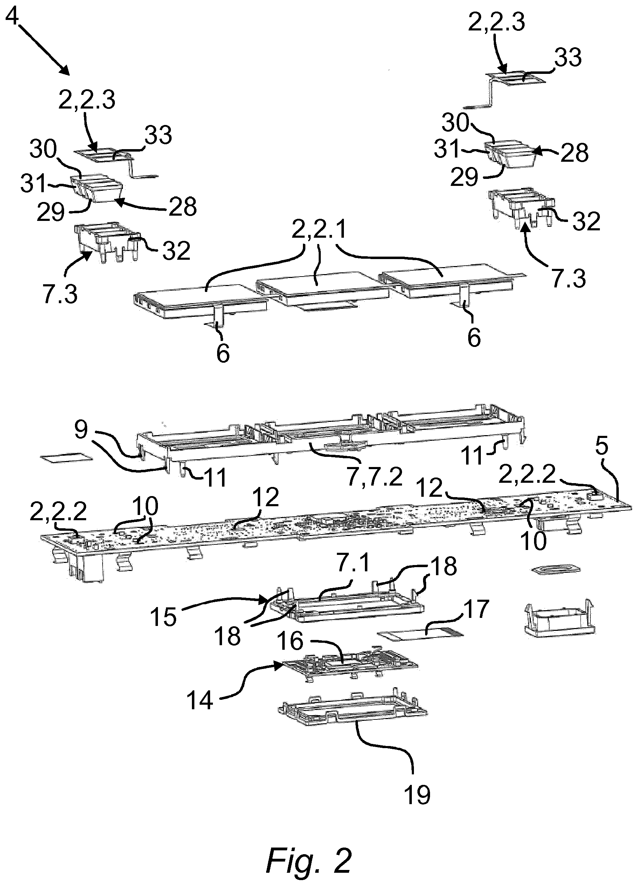

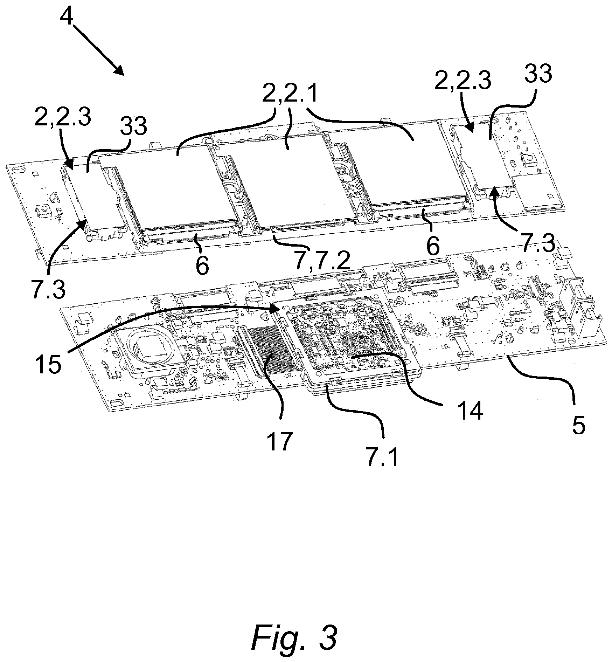

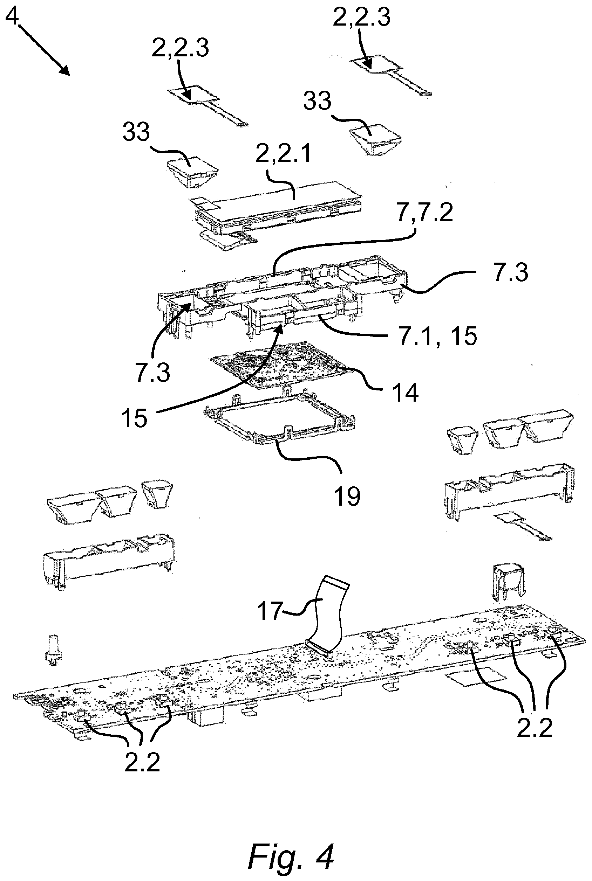

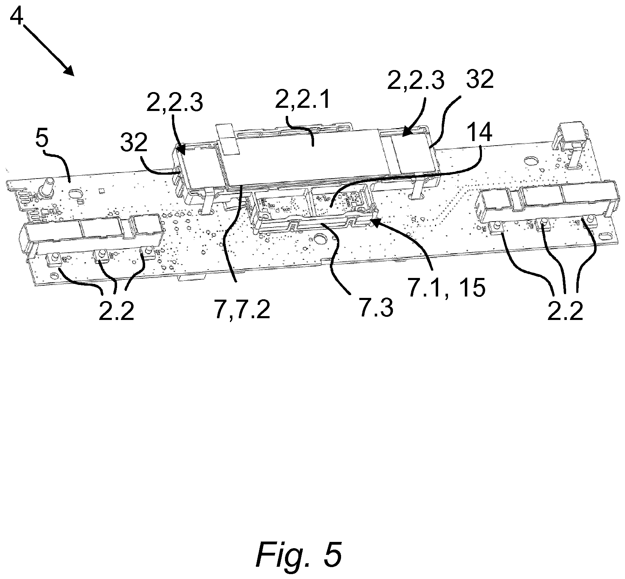

Ein in Fig. 1 beispielhaft dargestelltes Haushaltsgerät 1 ist als eine Waschmaschine 1a ausgebildet. Die Waschmaschine 1a weist ein oder mehrere, im Falle des ersten Ausführungsbeispiels gemäß Fig. 2 und Fig. 3 drei in einer Reihe nebeneinander angeordnete elektronische Displays 2.1 auf. Die elektronischen Displays 2.1 sind in einer Frontblende 3 des Haushaltsgeräts 1 untergebracht. Im Inneren des Haushaltsgeräts 1 sind, mit Ausnahme der sichtbaren Teile der elektronischen Displays 2.1 selbst, optisch hinter der Frontblende 3 verborgen, die übrigen Komponenten einer die elektronischen Displays 2.1 umfassenden elektronischen Benutzerschnittstelle 4 angeordnet. Eine solche elektronische Benutzerschnittstelle 4 ist in der Fig. 2 und Fig. 3 in einem ersten Ausführungsbeispiel und in der Fig. 4 und Fig. 5 in einem zweiten Ausführungsbeispiel jeweils in Alleinstellung näher dargestellt.

Die elektronische Benutzerschnittstelle 4 ist in einem in das Haushaltsgerät 1 eingebautem Zustand mit einer nicht näher dargestellten Steuervorrichtung des Haushaltsgeräts 1, bzw. der Waschmaschine 1a elektrisch verbunden.

Die elektronische Benutzerschnittstelle 4 weist eine Leiterplatte 5 und mehrere Ein- und/oder Ausgabemittel 2 auf, welche mit der Leiterplatte 5 elektrisch verbunden sind. Im Falle des ersten Ausführungsbeispiels gemäß Fig. 2 und Fig. 3 werden die mehrere Ein- und/oder Ausgabemittel 2 von drei elektronischen Displays 2.1, zwei Gruppen von jeweils drei Leuchtmitteln 2.2 und den Leuchtmitteln 2.2 jeweils zugeordneten Touch-Folien 2.3 gebildet. Die elektronischen Displays 2.1 stellen dabei optische Ausgabemittel 2 dar. Die Leuchtmittel 2.2 stellen in Verbindung mit Lichtleitern 28 dabei auch optische Ausgabemittel 2 dar. Die Touch-Folien 2.3 stellen manuelle Eingabemittel 2 dar. Indem die Touch-Folien 2.3 im Falle der vorliegenden Ausführungsbeispiele auf den mit den Leuchtmitteln 2.2 optisch verbundenen Lichtleitern 28 angebracht sind, bilden die Touch-Folien 2.3 zusammen mit den Leuchtmitteln 2.2 und Lichtleitern 28 insoweit jeweils ein kombiniertes Ein- und Ausgabemittel 2.

Die elektronische Benutzerschnittstelle 4 weist im Falle der vorliegenden Ausführungsbeispiele mehrere Halter 7 auf, durch welche mehrere der Ein- und/oder Ausgabemittel 2, d.h. die drei elektronischen Displays 2.1 und die Lichtleiter 28 mechanisch an der Leiterplatte 5 befestigt sind.

Die elektronischen Displays 2.1 sind an die Leiterplatte 5 elektrisch kontaktiert und die elektronische Benutzerschnittstelle 4 weist einen Display-Halterahmen 7.2 auf, der an der Leiterplatte 5 mechanisch befestigt ist und in den das wenigstens eine elektronische Display 2.1 eingesetzt ist.

Der Display-Halterahmen 7.2 weist dazu im Falle des vorliegenden Ausführungsbeispiels der Fig. 2 und Fig. 3 insgesamt drei Rahmenabteile 13a, 13b, 13c auf, von denen jedes Rahmenabteil 13a, 13b, 13c ausgebildet ist, ein elektronisches Display 2.1 aufzunehmen.

Demgemäß weist die elektronische Benutzerschnittstelle 4 des vorliegenden Ausführungsbeispiels also drei elektronische Displays 2.1 und zwar in der Bauart von TFT-Displays auf, sowie die Leiterplatte 5, auf welcher die drei elektronischen Displays 2.1 elektrisch beispielsweise mittels jeweils eines Flachbandkabels 6 elektrisch kontaktiert sind, und einen an der Leiterplatte 5 befestigten Display-Halterahmen 7.2, in den die drei elektronischen Displays 2.1 eingesetzt sind. Der Display-Halterahmen 7.2 weist wenigstens eine Display-Rastvorrichtung 28 auf, die ausgebildet ist, den Display-Halterahmen 7.2 auf der Leiterplatte 5 mechanisch zu befestigen. Mittels des Display-Halterahmen 7.2 ist eine Vormontage der drei elektronischen Displays 2.1 an dem Display-Halterahmen 7.2 möglich. Eine solche Vormontage der elektronischen Displays 2.1 an dem Display-Halterahmen 7.2 kann fern ab der eigentlichen Fertigungslinie des Haushaltsgeräts 1 erfolgen. Außerdem kann die so erhaltene Baugruppe von elektronischen Displays 2.1 und dem Display-Halterahmen 7.2 in einem ergänzenden oder separaten Montageschritt auf einfache Weise auf der Leiterplatte 5 vormontiert werden. Eine Endmontage der kompletten elektronischen Benutzerschnittstelle 4 kann dann in der eigentlichen Fertigungslinie des Haushaltsgeräts 1 erfolgen.

Die Display-Rastvorrichtung 28 bildet ganz allgemein ein formschlüssiges mechanisches Verbindungsmittel, welches ausgebildet ist, den Display-Halterahmen 7.2 auf der Leiterplatte 5 montieren zu können, ohne dass separate Befestigungsmittel und/oder separate Werkzeuge zur Befestigung notwendig wären. Die Display-Rastvorrichtung 28 kann ein, zwei oder wie dargestellt mehrere Rastzapfen 9 aufweisen. Die Leiterplatte 5 weist mehrere Öffnungen 10 auf und die Display-Rastvorrichtung 28 des Display-Halterahmen 7.2 weist eine gleiche Anzahl Rastzapfen 9 auf, die in ihren eingerasteten Zuständen in die Öffnungen 10 der Leiterplatte 5 eingreifen. Jeder Rastzapfen 9 ist im Falle des vorliegenden Ausführungsbeispiels einstückig mit dem Display-Halterahmen 7.2 als ein Kunststoffspritzgussteil hergestellt.

An einer der Leiterplatte 5 zugewandten Bodenseite weist der Display-Halterahmen 7.2 außerdem wenigstens einen, im Ausführungsbeispiel zwei Zentrierzapfen 11 auf, die sich von der Bodenseite des Display-Halterahmens 7.2 wegerstrecken. Die Zentrierzapfen 11 greifen in einer an der Leiterplatte 5 befestigten Montageposition des Halterahmens 7 in korrespondierende Löcher 12 in der Leiterplatte 5 ein. Indem die Zentrierzapfen 11 während des Montagevorgangs in die Löcher 12 der Leiterplatte 5 eindringen, wird der gesamte Display-Halterahmen 7.2 in seiner relativen Orientierung bezüglich der Leiterplatte 5 ausgerichtet. Durch eine genaue Ausrichtung des Display-Halterahmens 7.2 bezüglich der Leiterplatte 5 können die Rastzapfen 9 besonders genau und treffsicher in die Öffnungen 10 der Leiterplatte 5 eindringen, so dass der Montagevorgang des Display-Halterahmens 7.2 auf der Leiterplatte 5 verbessert ist.

Auch die Zentrierzapfen 11 sind im Falle des vorliegenden Ausführungsbeispiels, wie die Rastvorrichtung 8, und insbesondere die Rastzapfen 9 einstückig mit dem Display-Halterahmen 7.2 ausgebildet. Die Zentrierzapfen 11 können also an dem Kunststoffspritzgussteil des Display-Halterahmen 7.2 mit angeformt sein.

Die elektrischen Leuchtmittel 2.2 sind an die Leiterplatte 5 elektrisch kontaktiert. Die elektronische Benutzerschnittstelle 4 weist im Falle des vorliegenden ersten Ausführungsbeispiels zwei Lichtleiter-Halter 7.3 auf, die an der Leiterplatte 5 mechanisch befestigt sind und die Aufnahmetaschen 32 aufweisen, in welche die Lichtleiter 28 einzeln und separiert voneinander eingesetzt sind.

Die elektrischen Leuchtmittel 2.2 sind zur Erzeugung von Licht aus elektrischer Energie auf der Leiterplatte 5 kontaktiert. Jeder Lichtleiter 28 weist eine Einkopplungsfläche 29, eine Auskopplungsfläche 30 und einen Lichtleitabschnitt 31 auf, der ausgebildet ist, über die Einkopplungsfläche 29 eintretendes Licht des Leuchtmittels 2.2 an die Auskopplungsfläche 30 zu leiten, welche an ein Anzeigemittel 33 der elektronischen Benutzerschnittstelle 4 optisch angekoppelt ist. Die Touch-Folien 2.3 stellen dabei nicht nur manuelle Eingabemittel 2 dar, sondern bilden aufgrund ihrer optischen Ankopplung an die Lichtleiter 28 auch jeweils das jeweilige Anzeigemittel 33, da die Touch-Folien 2.3 im Falle der vorliegenden Ausführungsbeispiele auf den mit den Leuchtmitteln 2.2 optisch verbundenen Lichtleitern 28 angebracht sind und so zusammen mit den Leuchtmitteln 2.2 und Lichtleitern 28 insoweit jeweils ein kombiniertes Ein- und Ausgabemittel 2 bilden.

Erfindungsgemäß weist die elektronische Benutzerschnittstelle 4 eine von der Leiterplatte 5 separate Steuerplatine 14 auf, die wenigstens ein zum Ansteuern des wenigstens einen Ein- und/oder Ausgabemittels 2 ausgebildetes Steuerbauelement 16, wie beispielsweise ein mikroelektronischer Schaltkreis bzw. ein Mikroprozessor aufweist, und die mittels eines Platinenhalters 15 insbesondere ausschließlich mechanisch an der Leiterplatte 5 befestigt ist.

Der Platinenhalter 15 dient ausschließlich der mechanischen Befestigung der Steuerplatine 14 an der Leiterplatte 5 ohne dass über den Platinenhalter 15 auch die elektrischen Verbindungen geführt werden. Die elektrische Verbindung der auf der Steuerplatine 14 vorhandenen Steuerbauelemente 16, wie beispielsweise mikroelektronische Schaltkreise bzw. ein oder mehrere Mikroprozessoren werden elektrisch mit der Leiterplatte 5 über eine von dem Platinenhalter 15 separaten Steuerleitung 17 hergestellt.

Die Steuerplatine 14 ist somit allein mittels wenigstens einer vom Platinenhalter 15 separaten Steuerleitung 17 elektrisch mit der Leiterplatte 5 verbunden, über welche Steuerleitung 17 das wenigstens eine Ein- und/oder Ausgabemittel 2, insbesondere die elektronischen Displays 2.1, die elektrischen Leuchtmittel 2.2 und die Touch-Folien 2.3 durch die Steuerplatine 14 angesteuert sind.

Die Steuerplatine 14 ist im Falle der vorliegenden Ausführungsbeispiele also ausschließlich über die vom Platinenhalter 15 separate Steuerleitung 17, insbesondere eine als Flachbandkabel und/oder als ein FPC-Kabel ausgebildete Steuerleitung 17, elektrisch mit der Leiterplatte 5 verbunden.

Der Platinenhalter 15 weist im Falle der vorliegenden Ausführungsbeispiele einen Halterahmen 7.1 auf, in den die Steuerplatine 14 eingesetzt ist. Dazu weist der Halterahmen 7.1 wenigstens eine Rastvorrichtung 8.1 auf, durch welche der Halterahmen 7.1 auf der Leiterplatte 5 befestigt ist. Die Rastvorrichtung 8.1 weist mehrere, insbesondere vier Rasthaken 18 auf, welche in Löcher oder Randausnehmungen der Leiterplatte 5 verrasten.

Zusätzlich ist ein Deckel 19 vorgesehen, der an dem Platinenhalter 15 verrastet ist und der die in den Platinenhalter 15 eingesetzte Steuerplatine 14 abdeckt.

In dem zweiten Ausführungsbeispiel der Fig. 4 und Fig. 5 weist die elektronische Benutzerschnittstelle 4 auch eine von der Leiterplatte 5 separate Steuerplatine 14 auf, die wenigstens ein zum Ansteuern des wenigstens einen Ein- und/oder Ausgabemittels 2 ausgebildetes Steuerbauelement 16, wie beispielsweise ein mikroelektronischer Schaltkreis bzw. ein Mikroprozessor aufweist, und die mittels eines Platinenhalters 15 insbesondere ausschließlich mechanisch an der Leiterplatte 5 befestigt ist.

Im Falle des zweiten Ausführungsbeispiel sind ein einzelner Display-Halterahmen 7.2, zwei Lichtleiter-Halter 7.3 und/oder der Platinenhalter 15, insbesondere der Halterahmen 7.1, in den die Steuerplatine 14 eingesetzt ist, als ein einteiliger gemeinsamer Halter 7 ausgebildet.

Der Platinenhalter 15 bzw. der gemeinsame Halter 7 dient im Falle der der Steuerplatine 14 der ausschließlich mechanischen Befestigung an der Leiterplatte 5 ohne dass über den Platinenhalter 15 auch die elektrischen Verbindungen geführt werden. Die elektrische Verbindung der auf der Steuerplatine 14 vorhandenen Steuerbauelemente 16, wie beispielsweise mikroelektronische Schaltkreise bzw. ein oder mehrere Mikroprozessoren werden elektrisch mit der Leiterplatte 5 über eine von dem Platinenhalter 15 separaten Steuerleitung 17 hergestellt.

Die Steuerplatine 14 ist somit allein mittels wenigstens einer vom Platinenhalter 15 separaten Steuerleitung 17 elektrisch mit der Leiterplatte 5 verbunden, über welche Steuerleitung 17 das wenigstens eine Ein- und/oder Ausgabemittel 2, insbesondere das elektronischen Displays 2.1, zwei elektrische Leuchtmittel 2.2 und die Touch-Folien 2.3 durch die Steuerplatine 14 angesteuert sind.

Die Steuerplatine 14 ist also auch im Falle der vorliegenden zweiten Ausführungsbeispiele ausschließlich über die vom Platinenhalter 15 separate Steuerleitung 17, insbesondere eine als Flachbandkabel und/oder als ein FPC-Kabel ausgebildete Steuerleitung 17, elektrisch mit der Leiterplatte 5 verbunden.

Der Platinenhalter 15 weist im Falle der vorliegenden zweiten Ausführungsbeispiels einen einteilig mit dem Display-Halterahmen 7.2 und den zwei Lichtleiter-Haltern 7.3 ausgebildeten Halterahmen 7.1 auf, in den die Steuerplatine 14 eingesetzt ist.

In diesem zweiten Ausführungsbeispiel ist der Deckel 19, der an dem Platinenhalter 15 bzw. an dem einteiligen gemeinsamen Halter 7 verrastet ist und der die in den Platinenhalter 15 eingesetzte Steuerplatine 14 abdeckt, zwischen der Steuerplatine 14 und der Leiterplatte 5 angeordnet.

### Bezugszeichen

- 1: Haushaltsgerät
- 1a: Waschmaschine
- 2: Ein- / Ausgabemittel
- 2.1: elektronische Displays
- 2.2: Leuchtmittel
- 2.3: Touchfolien
- 3: Frontblende
- 4: Benutzerschnittstelle
- 5: Leiterplatte
- 6: Flachbandkabel
- 7: Halter
- 7.1: Halterahmen
- 7.2: Display-Halterahmen
- 7.3: Lichtleiter-Halter
- 8.1: Rastvorrichtung
- 8.2: Display-Rastvorrichtung
- 9: Rastzapfen
- 10: Öffnungen
- 11: Zentrierzapfen
- 12: Löcher
- 13a, 13b, 13c: Rahmenabteile
- 14: Steuerplatine
- 15: Platinenhalter
- 16: Steuerbauelement
- 17: Steuerleitung
- 18: Rashaken
- 19: Deckel
- 28: Lichtleiter
- 29: Einkopplungsfläche
- 30: Auskopplungsfläche
- 31: Lichtleiterabschnitt
- 32: Aufnahmetasche
- 33: Anzeigemittel

## Patentansprüche

1. Elektronische Benutzerschnittstelle, aufweisend eine Leiterplatte (5), wenigstens ein Ein- und/oder Ausgabemittel (2), welches mit der Leiterplatte (5) elektrisch verbunden ist, sowie wenigstens einen Halter (7), durch den das wenigstens eine Ein- und/oder Ausgabemittel (2) mechanisch an der Leiterplatte (5) befestigt ist, und eine von der Leiterplatte (5) separate Steuerplatine (14), die wenigstens ein zum Ansteuern des wenigstens einen Ein- und/oder Ausgabemittels (2) ausgebildetes Steuerbauelement (16) aufweist, und die mittels eines Platinenhalters (15) mechanisch an der Leiterplatte (5) befestigt ist, **dadurch gekennzeichnet, dass** die von der Leiterplatte (5) separate Steuerplatine (14) mittels des Platinenhalters (15) lediglich mechanisch an der Leiterplatte (5) befestigt ist, ohne dass eine elektrische Kontaktierung der Steuerplatine (14) an die Leiterplatte (5) über den Platinenhalter (15) erfolgt und
die Steuerplatine (14) mittels wenigstens einer vom Platinenhalter (15) separaten Steuerleitung (17) elektrisch mit der Leiterplatte (5) verbunden ist, über welche Steuerleitung (17) das wenigstens eine Ein- und/oder Ausgabemittel (2) durch die Steuerplatine (14) angesteuert ist.

2. Elektronische Benutzerschnittstelle nach Anspruch 1, **dadurch gekennzeichnet, dass** die Steuerplatine (14) ausschließlich über die wenigstens eine vom Platinenhalter (15) separate Steuerleitung (17), insbesondere eine als Flachbandkabel und/oder als ein FPC-Kabel ausgebildete Steuerleitung (17), elektrisch mit der Leiterplatte (5) verbunden ist.

3. Elektronische Benutzerschnittstelle nach einem der Ansprüche 1 oder 2, **dadurch gekennzeichnet, dass** der Platinenhalter (15) einen Halterahmen (7.1) aufweist, in den die Steuerplatine (14) eingesetzt ist, insbesondere wobei der Halterahmen (7.1) wenigstens eine Rastvorrichtung (8.1) aufweist, durch welche der Halterahmen (7.1) auf der Leiterplatte (5) befestigt ist.

4. Elektronische Benutzerschnittstelle nach einem der Ansprüche 1 bis 3, **dadurch gekennzeichnet, dass** der Platinenhalter (15) einen die in den Platinenhalter (15) eingesetzte Steuerplatine (14) abdeckenden Deckel (19) aufweist.

5. Elektronische Benutzerschnittstelle nach einem der Ansprüche 1 bis 4, **dadurch gekennzeichnet, dass** das wenigstens eine Ein- und/oder Ausgabemittel (2) ein elektronisches Display (2.1) ist, das an die Leiterplatte (5) elektrisch kontaktiert ist, und die elektronische Benutzerschnittstelle (4) einen Display-Halterahmen (7.2) aufweist, der an der Leiterplatte (5) mechanisch befestigt ist und in den das wenigstens eine elektronische Display (2) eingesetzt ist.

6. Elektronische Benutzerschnittstelle nach Anspruch 5, **dadurch gekennzeichnet, dass** der Display-Halterahmen (7.2) wenigstens zwei Rahmenabteile (13a, 13b, 13c) aufweist, von denen jedes Rahmenabteil (13a, 13b, 13c) ausgebildet ist, ein elektronisches Display (2.1) aufzunehmen.

7. Elektronische Benutzerschnittstelle nach einem der Ansprüche 1 bis 6, **dadurch gekennzeichnet, dass** der Display-Halterahmen (7.2), der Lichtleiter-Halter (7.3) und/oder der Platinenhalter (15), insbesondere der Halterahmen (7.1), in den die Steuerplatine (14) eingesetzt ist, als ein einteiliger gemeinsamer Halter (7) ausgebildet ist.

8. Elektronische Benutzerschnittstelle nach einem der Ansprüche 1 bis 7, **dadurch gekennzeichnet, dass** das wenigstens eine Ein- und/oder Ausgabemittel (2) ein elektrisches Leuchtmittel (2.2) aufweist, das zur Erzeugung von Licht aus elektrischer Energie auf der Leiterplatte (5) kontaktiert ist, und das wenigstens einen Lichtleiter (28), der eine Einkopplungsfläche (29), eine Auskopplungsfläche (30) und einen Lichtleitabschnitt (31) aufweist, der ausgebildet ist, über die Einkopplungsfläche (29) eintretendes Licht des Leuchtmittels (2.2) an die Auskopplungsfläche (30) zu leiten, welche an ein Anzeigemittel (33) der elektronischen Benutzerschnittstelle (4) optisch angekoppelt ist, und an der Leiterplatte (5) ein Lichtleiter-Halter (7.3) befestigt ist, der den wenigstens einen Lichtleiter (28) trägt.

9. Elektronische Benutzerschnittstelle nach Anspruch 8, **dadurch gekennzeichnet, dass** der Lichtleiter-Halter (7.3) wenigstens eine Aufnahmetasche (32) aufweist, in die der wenigstens eine Lichtleiter (28) eingesetzt ist.

10. Haushaltsgerät, aufweisend eine Elektronische Benutzerschnittstelle (4) nach einem der Ansprüche 1 bis 9.

## Claims

1. Electronic user interface, having a circuit board (5), at least one input and/or output means (2) which is electrically connected to the circuit board (5), and at least one holder (7) by which the at least one input and/or output means (2) is mechanically fastened to the circuit board (5), and a control board (14) which is separate from the circuit board (5), has at least one control component (16) embodied to control the at least one input and/or output means (2) and is mechanically fastened to the circuit board (5) by means of a board holder (15), **characterised in that** the control board (14) which is separate from the circuit board (5) is merely mechanically fastened to the circuit board (5) by means of the board holder (15), without electrical contacting of the control board (14) to the circuit board (5) taking place via the board holder (15), and the control board (14) is electrically connected to the circuit board (5) by means of at least one control line (17) separate from the board holder (15), via which control line (17) the at least one input and/or output means (2) is controlled by the control board (14).

2. Electronic user interface according to claim 1, **characterised in that** the control board (14) is electrically connected to the circuit board (5) exclusively via the at least one control line (17) which is separate from the board holder (15), in particular a control line (17) embodied as a flat ribbon cable and/or as an FPC cable.

3. Electronic user interface according to one of claims 1 to 2, **characterised in that** the board holder (15) has a holding frame (7.1) into which the control board (14) is inserted, in particular wherein the holding frame (7.1) has at least one latching device (8.1), by which the holding frame (7.1) is fastened to the circuit board (5).

4. Electronic user interface according to one of claims 1 to 3, **characterised in that** the board holder (15) has a cover (19) which covers the control board (14) inserted into the board holder (15).

5. Electronic user interface according to one of claims 1 to 4, **characterised in that** the at least one input and/or output means (2) is an electronic display (2.1) which is electrically contacted to the circuit board (5), and the electronic user interface (4) has a display holding frame (7.2) which is mechanically fastened to the circuit board (5) and into which the at least one electronic display (2) is inserted.

6. Electronic user interface according to claim 5, **characterised in that** the display holding frame (7.2) has at least two frame compartments (13a, 13b, 13c), of which each frame compartment (13a, 13b, 13c) is embodied to accommodate an electronic display (2.1) .

7. Electronic user interface according to one of claims 1 to 6, **characterised in that** the display holding frame (7.2), the light guide holder (7.3) and/or the board holder (15), in particular the holding frame (7.1) into which the control board (14) is inserted, is embodied as a one-piece common holder (7).

8. Electronic user interface according to one of claims 1 to 7, **characterised in that** the at least one input and/or output means (2) has an electrical illuminant (2.2) which is contacted on the circuit board (5) to generate light from electrical energy, and which has at least one light guide (28) which has a coupling surface (29), a decoupling surface (30) and a light guide section (31) which is embodied to guide light from the illuminant (2.2) entering via the coupling surface (29) to the decoupling surface (30), which is optically coupled to a display means (33) of the electronic user interface (4), and a light guide holder (7.3) is fastened to the circuit board (5), and carries the at least one light guide (28).

9. Electronic user interface according to claim 8, **characterised in that** the light guide holder (7.3) has at least one receiving pocket (32) into which the at least one light guide (28) is inserted.

10. Household appliance, having an electronic user interface (4) according to one of claims 1 to 9.

## Revendications

1. Interface utilisateur électronique, comprenant une carte de circuit imprimé (5), au moins un moyen d'entrée et/ou de sortie (2) qui est relié électriquement à la carte de circuit imprimé (5), ainsi qu'au moins un support (7), par lequel l'au moins un moyen d'entrée et/ou de sortie (2) est fixé mécaniquement à la carte de circuit imprimé (5), et une platine de commande (14) séparée de la carte de circuit imprimé (5), qui comprend au moins un composant de commande (16) configuré pour exciter le au moins un moyen d'entrée et/ou de sortie (2), et qui est fixée mécaniquement à la carte de circuit imprimé (5) au moyen d'un support de platine (15),
**caractérisée en ce que** la platine de commande (14) séparée de la carte de circuit imprimé (5) est fixée uniquement mécaniquement à la carte de circuit imprimé (5) au moyen du support de platine (15), sans qu'il ne se produise une mise en contact électrique de la platine de commande (14) avec la carte de circuit imprimé (5) par le biais du support de platine (15), et
la platine de commande (14) est reliée électriquement à la carte de circuit imprimé (5) au moyen d'au moins une ligne de commande (17) séparée du support de platine (15), via laquelle ligne de commande (17) le au moins un moyen d'entrée et/ou de sortie (2) est excité par la platine de commande (14).

2. Interface utilisateur électronique selon la revendication 1, **caractérisée en ce que** la platine de commande (14) est reliée électriquement à la carte de circuit imprimé (5) uniquement par l'intermédiaire de la au moins une ligne de commande (17) séparée du support de platine (15), en particulier d'une ligne de commande (17) configurée sous forme d'un câble en nappe et/ou d'un câble FPC.

3. Interface utilisateur électronique selon l'une des revendications 1 ou 2, **caractérisée en ce que** le support de platine (15) comprend un cadre de support (7.1), dans lequel la platine de commande (14) est insérée, en particulier dans lequel le cadre de support (7.1) comprend au moins un dispositif d'encliquetage (8.1) au moyen duquel le cadre de support (7.1) est fixé sur la carte de circuit imprimé (5).

4. Interface utilisateur électronique selon l'une des revendications 1 à 3, **caractérisée en ce que** le support de platine (15) comprend un couvercle (19) recouvrant la platine de commande (14) insérée dans le support de platine (15).

5. Interface utilisateur électronique selon l'une des revendications 1 à 4, **caractérisée en ce que** le au moins un moyen d'entrée et/ou de sortie (2) est un dispositif d'affichage électronique (2.1), qui est en contact électrique avec la carte de circuit imprimé (5), et l'interface utilisateur électronique (4) comprend un cadre de support de dispositif d'affichage (7.2) qui est fixé mécaniquement à la carte de circuit imprimé (5) et dans lequel le au moins un dispositif d'affichage électronique (2) est inséré.

6. Interface utilisateur électronique selon la revendication 5, **caractérisée en ce que** le cadre de support de dispositif d'affichage (7.2) comprend au moins deux compartiments de cadre (13a, 13b, 13c), chaque compartiment de cadre (13a, 13b, 13c) étant configuré pour loger un dispositif d'affichage électronique (2.1).

7. Interface utilisateur électronique selon l'une des revendications 1 à 6, **caractérisée en ce que** le cadre de support de dispositif d'affichage (7.2), le support de guide de lumière (7.3) et/ou le support de platine (15), en particulier le cadre de support (7.1), dans lequel la platine de commande (14) est insérée, est(sont) configuré(s) sous forme d'un support commun (7) d'une seule pièce.

8. Interface utilisateur électronique selon l'une des revendications 1 à 7, **caractérisée en ce que** le au moins un moyen d'entrée et/ou de sortie (2) comprend un organe lumineux électrique (2.2) qui est mis en contact sur la carte de circuit imprimé (5) pour produire de la lumière à partir d'énergie électrique, et comprend au moins un guide de lumière (28) comportant une surface de couplage (29), une surface de découplage (30) et une section de guide de lumière (31) qui est configurée pour diriger la lumière de l'organe lumineux (2.2) entrant par la surface de couplage (29) sur la surface de découplage (30), laquelle est couplée optiquement à un moyen d'affichage (33) de l'interface utilisateur électronique (4), et un support de guide de lumière (7.3), qui porte au moins un guide de lumière (28), est fixé à la carte de circuit imprimé (5).

9. Interface utilisateur électronique selon la revendication 8, **caractérisée en ce que** le support de guide de lumière (7.3) comprend au moins une poche de réception (32), dans laquelle l'au moins un guide de lumière (28) est inséré.

10. Appareil ménager, comprenant une interface utilisateur électronique (4) selon l'une des revendications 1 à 9.
